# EUROPÄISCHE PATENTSCHRIFT

(11) **EP 3 652 546 B1**
(45) Veröffentlichungstag und Bekanntmachung des Hinweises auf die Patenterteilung: **29.03.2023**
(21) Anmeldenummer: 18768780.1
(22) Anmeldetag: 22.08.2018
(51) Int. Cl.: G01R 19/165, B60L 5/00

(54) **VERFAHREN SOWIE VORRICHTUNG ZUR ÜBERPRÜFUNG EINER KONTAKTIERUNG EINES STROMABNEHMERS**
METHOD AND DEVICE FOR TESTING WHETHER A CURRENT COLLECTOR IS IN CONTACT
PROCÉDÉ ET DISPOSITIF DE VÉRIFICATION DE LA MISE EN CONTACT ÉLECTRIQUE D'UN PANTOGRAPHE

(30) Priorität: 30.08.2017 DE 102017215135
(43) Veröffentlichungstag der Anmeldung: 20.05.2020
(73) Patentinhaber: Siemens Mobility GmbH, 81739 München (DE)
(72) Erfinder: BÜHS, Florian, 10777 Berlin (DE); STARK, Thomas, 15569 Woltersdorf (DE); SÄNGER, Göran, 12587 Berlin (DE); TOLKSDORF, Andre, 12555 Berlin (DE)
(74) Vertreter: Siemens Patent Attorneys
(86) Internationale Anmeldenummer: PCT/EP2018/072673
(87) Internationale Veröffentlichungsnummer: WO 2019/042843

(56) Entgegenhaltungen:
- WO-A2-2012/163762
- DE-A1-102014 116 736
- JP-B2- 5 833 952
- RU-U1- 41 280
- US-A1- 2011 030 574
- US-B2- 6 523 654

## Beschreibung

Die Erfindung betrifft ein Verfahren sowie eine Vorrichtung zur Überprüfung einer Kontaktierung zwischen einem Paar von Endkontaktelementen eines Stromabnehmers mit einem sich in eine Fahrtrichtung erstreckenden Fahrdraht einer Oberleitung.

JP5833952B2 offenbart ein elektrisches Eisenbahnsystem mit einem Fahrdraht und mit einem elektrischen Schienenfahrzeug, welches auf Schienen betrieben wird. Das Schienenfahrzeug umfasst einen Stromabnehmer, der als Pantograph ausgebildet sein kann. Der Pantograph umfasst ein sich auf einem Untergestell abstützendes Traggestänge, welches eine Wippe trägt. Das Traggestänge kann als Scherengestänge oder als Halbschere ausgebildet sein. Eine Messanordnung umfasst zur Messung einer Kontaktspannung ein erstes Kontaktstück und ein zweites Kontaktstück, die auf einer Wippe angeordnet sind, sowie ein drittes Kontaktstück und ein Messkontaktstück, die auf einer benachbarten Wippe angeordnet sind. Die beiden Wippen stützen sich auf einem Wippenträger ab. Das Messkontaktstück weist eine abtastendes Kontaktstück als Leiter zum Fahrdraht und ein Unterbrecherstück als Isolator zwischen dem Spannung abgreifenden Kontaktstück und der Wippe auf. Spannungsmessgeräte sind jeweils zwischen den Kontaktstücken und dem Messkontaktstück geschaltet. Die Messanordnung misst die Potenzialdifferenz zwischen dem Fahrdraht und jedem der Kontaktstücke mittels der Spannungsmessgeräten.

Heutzutage werden im Rahmen der Elektrifizierung des Automobilbereiches verschiedene Arten zur elektrischen Energieversorgung von elektromotorisch angetriebenen Kraftfahrzeugen eingesetzt. Eine dieser Arten ist beispielsweise eine Versorgung eines Kraftfahrzeuges mittels einer über einer Fahrbahn angeordneten Oberleitung, wie sie nach bekannter Weise bei Schienenfahrzeugen eingesetzt ist. Zur Energieversorgung weisen hierzu ausgebildete Kraftfahrzeuge, speziell Lastkraftwagen einen Stromabnehmer auf, welcher mit der Oberleitung kontaktiert und somit die Energieversorgung sicherstellt.

Eine Kontaktierung des Stromabnehmers mit der Oberleitung ist nicht nur aus Sicht der Energieübertragung sicherzustellen, auch aus einem sicherheitstechnischen Hintergrund ist eine funktionsfähige Kontaktierung des Stromabnehmers mit der Oberleitung wichtig.

Fährt beispielsweise das Kraftfahrzeug seitlich außerhalb eines definierten und zulässigen Bereichs, so besteht die Gefahr, dass der Stromabnehmer nicht mehr funktionsfähig mit der Oberleitung kontaktiert. Mit andern Worten: Die Oberleitung "gleitet". von dem Stromabnehmer herunter. Ein derartiges Heruntergleiten der Oberleitung von dem Stromabnehmer kann eine Beschädigung des Stromabnehmers und / oder der Oberleitung und somit möglicherweise auch des Fahrzeuges zur Folge haben.

Ausgehend hiervon liegt der Erfindung die Aufgabe zugrunde ein Verfahren sowie eine Vorrichtung anzugeben, mit deren Hilfe eine Kontaktierung mit einer Oberleitung einfach und zuverlässig erfolgt.

Die auf das Verfahren gerichtete Aufgabe wird erfindungsgemäß gelöst durch ein Verfahren mit den Merkmalen des Anspruchs 1.

Vorteilhafte Ausgestaltungen, Weiterbildungen und Varianten sind Gegenstand der Unteransprüche.

Das Verfahren ist zur Überprüfung einer Kontaktierung eines Stromabnehmers mit einem sich in eine Fahrtrichtung erstreckenden Fahrdraht einer Oberleitung ausgebildet. Unter Oberleitung wird vorliegend speziell eine elektrische Versorgungsleitung verstanden, welche den Fahrdraht aufweist, der mittels beispielsweise mehrerer Tragseile oberhalb einer Fahrbahn angeordnet ist. Typischerweise ist der Fahrdraht mit einer (Versorgungs-)Spannung beaufschlagt, welche von dem Stromabnehmer "abgegriffen" wird.

Der Stromabnehmer ist an einem elektromotorisch angetriebenen Kraftfahrzeug angeordnet. Unter elektromotorisch angetriebenem Kraftfahrzeug wird vorliegend speziell ein (Personen-)Kraftfahrzeug verstanden, das einen Elektromotor als Fahrmotor aufweist, entweder nach Art eines hybriden Kraftfahrzeugs (Kombination aus Verbrennungsmotor und Elektromotor) oder nach Art eines rein elektromotorisch angetriebenen Kraftfahrzeugs. Der Einfachheit halber wird im Folgenden das elektromotorisch angetriebene Kraftfahrzeug kurz als Kraftfahrzeug bezeichnet. Weiterhin weist der Stromabnehmer zwei quer zur Fahrtrichtung orientierte Kontaktbereiche auf, die beabstandet voneinander in Fahrtrichtung hintereinander angeordnet sind. Die Kontaktbereiche sind üblicherweise als Schleifleisten ausgebildet, sodass die Oberleitung, insbesondere der Fahrdraht, mit diesen zur Energieversorgung kontaktiert. Der Fahrdraht "schleift" somit beispielsweise in einem Fahrbetrieb über die Kontaktbereiche.

Jeweils endseitig weist ein Kontaktbereich ein Endkontaktelement auf. Die Endkontaktelemente weisen üblicherweise eine Biegung entgegen einer Vertikalrichtung "nach unten" auf und werden deshalb aufgrund ihrer (gebogenen) Form auch als Hörner bezeichnet. Mit anderen Worten: Die Form der Endkontaktelemente beschreibt bevorzugt einen Teil eines entgegen der Vertikalrichtung orientierten Kreisbogens.

Jeweils gleichendseitig angeordnete Endkontaktelemente bilden ein Paar und sind mit einer Messvorrichtung verbunden, mit der eine elektrische Zustandsgröße erfasst wird. Unter der Messvorrichtung wird vorliegend beispielsweise eine Messschaltung mit einem Strom- oder Spannungserfassungselement verstanden. Mit anderen Worten: In Fahrtrichtung betrachtet bilden beispielsweise die linken Endkontaktelemente der Kontaktbereiche ein linkes Kontaktelementepaar, das mit der Messvorrichtung verbunden ist. Vorzugsweise ist sowohl das linke Endkontaktelementepaar als auch das rechte Endkontaktelementepaar mit jeweils einer Messvorrichtung oder mit einer gemeinsamen Messvorrichtung verbunden. Vorliegend bezieht sich rechts und links in Fahrtrichtung betrachtet. In Abhängigkeit der erfassten Zustandsgröße wird ermittelt, ob die Endkontaktelemente mit der Oberleitung kontaktiert sind.

Dieser Ausgestaltung liegt die Überlegung zugrunde, dass bei einer Überschreitung eines maximal zulässigen lateralen Versatzes des Kraftfahrzeuges bezogen zur Oberleitung der Stromabnehmer ebenfalls nicht mehr innerhalb eines zulässigen lateralen Versatzes zur Oberleitung positioniert ist. Unter maximal zulässigem lateralem Versatz wird vorliegend eine maximale parallele Verschiebung des Kraftfahrzeuges und somit auch des Stromabnehmers zur Oberleitung verstanden, sodass eine funktionsfähige Kontaktierung des Stromabnehmers mit der Oberleitung noch sichergestellt ist. Ein Verlassen des maximal zulässigen lateralen Versatzes kann ein "Herunterrutschen" der Oberleitung von dem Stromabnehmer zur Folge haben.

Durch die Erfassung der Kontaktierung der Endkontaktelemente mit der Oberleitung bei einem "drohenden" Verlassen des maximal zulässigen lateralen Versatzes kann somit ein derartiges "Herunterrutschen" verhindert werden und geeignete Gegenmaßnahmen ergriffen werden. Zur Erfassung der Kontaktierung wird vorliegend beispielsweise ein Stromkreis geschlossen, der durch die Messvorrichtung und die Verbindung zu den jeweiligen Endkontaktelement ausgebildet wird. D.h., dass wenn sich das Kraftfahrzeug beispielsweise (in Fahrtrichtung betrachtet) lateral nach links von der Oberleitung entfernt, "wandert" die Oberleitung auf dem Stromabnehmer (in Fahrtrichtung betrachtet) nach rechts. Sobald die Oberleitung die beiden rechten Endkontaktelemente erreicht, verbindet sie diese elektrisch miteinander und schließt somit den durch die Messvorrichtung ausgebildeten Stromkreis und die elektrische Zustandsgröße wird erfasst. Mit anderen Worten: Die Endkontaktelemente und der Fahrdraht funktionieren also nach dem Prinzip eines mechanischen Schalters, bei dem die Endkontaktelemente zu verbindenden Schaltkontakte und der Fahrdraht ein Schaltelement ausbilden.

Anhand der Zustandsgröße wird also ermittelt, dass sich der Stromabnehmer (und somit auch das Kraftfahrzeug) nicht mehr innerhalb des maximal zulässigen lateralen Versatzes aufhält und ein "Herunterrutschen" der Oberleitung von dem Stromabnehmer droht. Dies wird beispielsweise einem Führer des Kraftfahrzeugs mitgeteilt, sodass dieser beispielsweise eine Gegensteuerbewegung ausführen kann. Alternativ wird ein Signal an eine Fahrsteuerungseinheit übermittelt, die anschließend eine Korrekturbewegung beispielsweise in Form einer Lenkbewegung durchführt, um das Kraftfahrzeug erneut innerhalb des maximal zulässigen lateralen Versatzes zu positionieren. Unter der Fahrsteuerungseinheit wird vorliegend eine Einheit verstanden, die beispielsweise nach Art eines aktiven Spurhalteassistenten ausgebildet ist und somit das Kraftfahrzeug autonom steuert. Beispielsweise ist auch eine Verbindung mit einer Motorkontrolleinheit einer Stromabnehmerstelleinheit ermöglicht, sodass diese eine Korrekturbewegung des Stromabnehmers durchführt, um diesen erneut innerhalb des maximal zulässigen lateralen Versatzes zu positionieren.

Das beschriebene Verfahren erfolgt analog auch bei einem Verlassen des Kraftfahrzeuges nach rechts aus dem maximal zulässigen lateralen Versatz.

Der Vorteil dieser Ausgestaltung ist, dass ein drohender Kontaktverlust des Stromabnehmers mit der Oberleitung detektiert wird und somit verhindert werden kann. Zudem ist eine Detektion einer Kontaktierung der Endkontaktelemente mit der Oberleitung ohne zusätzliche und aufwändige Sensoreinheiten ermöglicht.

Bevorzugt ist die erfasste elektrische Zustandsgröße eine elektrische Spannung. Hierbei wird bei einer Kontaktierung der Endkontaktelemente mit der Oberleitung seitens der Messvorrichtung beispielsweise ein Spannungsabfall erfasst. Alternativ ist die erfasste elektrische Zustandsgröße der elektrische Strom, welcher bei einer Kontaktierung der Endkontaktelemente mit der Oberleitung beispielsweise durch ein Widerstandselement fließt und somit die Kontaktierung detektiert.

Erfindungsgemäß sind die Endkontaktelemente elektrisch leitend ausgebildet und zudem gegenüber den Kontaktbereichen isoliert ausgebildet. Hierdurch wird zum Einen eine für das Verfahren notwendige elektrische Leitfähigkeit der Endkontaktelemente erreicht und zum Anderen wird durch die Isolierung eine unerwünschte elektrische Kontaktierung oder Verbindung der Endkontaktelemente mit den Kontaktbereichen verhindert.

Die Messvorrichtung weist gemäß einer bevorzugten Weiterbildung eine eigene (Strom- und / oder) Spannungsversorgung auf, sodass die Kontaktierung der Endkontaktelemente mit der Oberleitung unabhängig eines elektrischen Zustands der Oberleitung erfasst wird. Unter dem elektrischen Zustand der Oberleitung wird vorliegend verstanden, ob die Oberleitung - speziell der Fahrdraht - mit einer Spannung beaufschlagt ist oder beispielsweise aufgrund von Wartungsarbeiten spannungsfrei geschaltet ist.

Gemäß einer bevorzugten Weiterbildung weist die Messvorrichtung zumindest ein Messwiderstandselement und ein Referenzwiderstandselement auf. Mittels der Messvorrichtung wird bevorzugt ein Spannungsabfall über das Referenzwiderstandselement ermittelt. Der Spannungsabfall variiert hierbei in Abhängigkeit einer Kontaktierung der Endkontaktelemente mit der Oberleitung. Hierzu sind das Messwiderstandselement und das Referenzwiderstandselement bevorzugt seriell und speziell nach Art einer Spannungsteiler-Schaltung innerhalb der Messvorrichtung verschaltet. Hierdurch wird auf eine einfach Weise ein Spannungsabfall und somit eine Kontaktierung der Endkontaktelemente mit der Oberleitung erfasst. Die beiden Endkontaktelemente, welche mit der Messvorrichtung verbunden sind, sind dabei parallel zu dem Messwiderstandselement angeschlossen, sodass bei einer Kontaktierung mit der Oberleitung das Messwiderstandselement elektrisch überbrückt wird. Im Folgenden wird eine genaue Funktion einer derartigen Spannungsteiler-Schaltung noch näher erläutert.

Bevorzugt erfolgt der Spannungsabfall bei einer Nichtkontaktierung der Endkontaktelemente mit dem Fahrdraht über das Messwiderstandselement und das Referenzwiderstandselement. Unter Nichtkontaktierung wird vorliegend zum Einen verstanden, dass der Stromabnehmer überhaupt nicht mit der Oberleitung verbunden ist und zum Anderen, dass der Stromabnehmer mit den Kontaktbereichen lediglich innerhalb des bereits erwähnten maximalen zulässigen lateralen Versatzes mit der Oberleitung kontaktiert ist.

Die Gesamtspannung, d.h. der Spannungsabfall der Gesamtspannung der eigenen Versorgung der Messvorrichtung teilt sich somit auf das Messwiderstandselement und das Referenzwiderstandselement auf.

Ein wesentlicher Aspekt ist vorliegend auch darin zu sehen, dass der Spannungsabfall bei einer Kontaktierung der Endkontaktelemente mit der Oberleitung lediglich über das Referenzwiderstandselement erfolgt. Hierzu wird das Messwiderstandselement, wie bereits erwähnt, aufgrund der Kontaktierung mit der Endkontaktelemente mit der Oberleitung überbrückt (auch als kurzgeschlossen bezeichnet). Mit anderen Worten: Bei einer Kontaktierung mit der Oberleitung schließt sich ein parallel zu dem Messwiderstandselement angeschlossene Teilkreis, der durch die Endkontaktelemente ausgebildet wird. Hierdurch ist parallel zu dem Messwiderstandselement eine im Vergleich zum Messwiderstandselement niederohmige Verbindung ausgebildet, über die ein Strom fließt. Schaltungstechnisch betrachtet weist die Messvorrichtung somit nur noch lediglich das Referenzwiderstandselement auf. Die Spannung der Versorgung der Messvorrichtung fällt folglich lediglich über das Referenzwiderstandselement ab. Der Spannungsabfall am Referenzwiderstandselement weist somit einen höheren Wert auf als der Spannungsabfall bei nicht überbrücktem Messwiderstandselement. Diese relative Erhöhung des Spannungsabfalls am Referenzwiderstandselement wird zur Detektion einer Kontaktierung der Endkontaktelemente mit der Oberleitung herangezogen.

Die Auswertung des Spannungsabfalls am Referenzwiderstandselement erfolgt beispielsweise mittels einer Auswerteeinheit. Die Auswerteeinheit ist beispielsweise in die bereits erwähnte Motorkontrolleinheit der Stromabnehmerstelleinheit integriert und mittels einer beispielsweise drahtgebundenen oder drahtlosen Verbindung mit der Messvorrichtung verbunden. Alternativ ist die Auswerteeinheit innerhalb des Kraftfahrzeuges angeordnet.

Zweckdienlicherweise wird bei einer Kontaktierung der Endkontaktelemente mit der Oberleitung ein Warnsignal ausgegeben, beispielsweise an die Fahrsteuerungseinheit und / oder an den Führer des Kraftfahrzeuges. Alternativ wird beispielswiese von der Auswerteeinheit ein Stellsignal an die Stromabnehmerstelleinheit ausgegeben, sodass die Stromabnehmerstelleinheit mittels einer Steuerbewegung eine Position des Stromabnehmers in Bezug zur Oberleitung korrigiert. Beispielsweise trennt die Stromabnehmerstelleinheit den Stromabnehmer von dem Fahrdraht.

Die auf die Vorrichtung gerichtete Aufgabe wird erfindungsgemäß gelöst durch eine Vorrichtung mit den Merkmalen des Anspruchs 8.

Die Vorrichtung ist zur Überprüfung einer Kontaktierung eines an einem elektromotorisch angetriebenen Kraftfahrzeug angeordneten Stromabnehmers mit einem Fahrdraht einer Oberleitung ausgebildet und dient insbesondere zur Durchführung des zuvor beschriebenen Verfahrens.

Die im Hinblick auf das Verfahren aufgeführten Vorteile und bevorzugen Ausgestaltungen sind sinngemäß auf die Vorrichtung zu übertragen und umgekehrt.

Der Einfachheit halber wird im Folgenden das elektromotorisch angetriebene Kraftfahrzeug kurz als Kraftfahrzeug bezeichnet.

Die Vorrichtung weist den Stromabnehmer auf, der in und entgegen einer Vertikalrichtung verfahrbar ist und zur Kontaktierung mit der Oberleitung in Vertikalrichtung "von unten" an die Oberleitung herangefahren wird. Der Stromabnehmer weist zumindest zwei quer zur Fahrtrichtung orientierte Kontaktbereiche auf. Die Kontaktbereiche sind üblicherweise als Schleifleisten ausgebildet und in Fahrtrichtung voneinander beabstandet hintereinander angeordnet. Zusätzlich sind an den Kontaktbereichen jeweils endseitig Endkontaktelemente angeordnet. Alternativ sind die Endkontaktelemente als ein separates Bauteil an der Schleifleiste angeordnet.

Weiterhin weist die Vorrichtung die Messvorrichtung zur Erfassung einer elektrischen Zustandsgröße, beispielsweise der elektrischen Spannung auf. Jeweils zwei gleichendseitig an den Kontaktbereichen angeordnete Endkontaktelemente bilden ein Paar (auch als Endkontaktelementepaar bezeichnet) und sind vorzugsweise mit der Messvorrichtung verbunden. Jeweils die links der Oberleitung angeordneten Endkontaktelemente sind mit der Messvorrichtung verbunden. Analog sind die rechts der Oberleitung angeordneten Endkontaktelemente mit der Messvorrichtung verbunden. Analog sind beide Endkontaktelementepaare (links und rechts) mit jeweils einer Messvorrichtung verbunden. Zudem ist die Messvorrichtung derart ausgebildet, dass in Abhängigkeit der erfassten Zustandsgröße eine Ermittlung erfolgt, ob die Endkontaktelemente mit der Oberleitung kontaktiert sind.

Der Erfassung der Kontaktierung der Endkontaktelemente mittels der Vorrichtung liegt der Gedanke zugrunde, dass durch den Strompfad ein Strompfad innerhalb der Messvorrichtung kurzgeschlossen ist und somit beispielsweise ein geänderter Spannungsabfall innerhalb der Messvorrichtung erfassbar ist.

Der Vorteil dieser Ausgestaltung ist, dass ein "drohender" Verlust der Kontaktierung des Stromabnehmers mit dem Fahrdraht frühzeitig erkennbar ist und somit vermeidbar ist. Beispielsweise ist hiermit erreicht, dass sich das Kraftfahrzeug und somit auch der Stromabnehmer im Betrieb einen maximal zulässigen lateralen Versatz nicht überschreiten.

Gemäß einer bevorzugten Ausbildung weist die Messvorrichtung ein Messwiderstandselement und ein Referenzwiderstandselement auf, sodass ein Spannungsabfall über das Referenzwiderstandselement in Abhängigkeit einer Kontaktierung der Endkontaktelemente mit dem Fahrdraht erfassbar ist. Hierzu sind das Messwiderstandselement und das Referenzwiderstandselement bevorzugt seriell nach Art einer Spannungsteiler-Schaltung angeschlossen. Die Endkontaktelemente sind hierbei parallel zu dem Messwiderstandselement angeschlossen, sodass durch eine Kontaktierung der Endkontaktelemente mit der Oberleitung der Messwiderstand über die parallel geschalteten Endkontaktelemente elektrisch überbrückbar ist. Eine derartige Kontaktierung der Endkontaktelemente hat somit eine Änderung des Spannungsabfalls am Referenzwiderstandselement zur Folge, da aufgrund der Überbrückung die gesamte Versorgungsspannung der Messvorrichtung an dem Referenzwiderstandselement abfällt. Bei nicht kontaktierten Endkontaktelementen fällt die Versorgungsspannung der Messvorrichtung beispielsweise am Messwiderstandselement und am Referenzwiderstandselement ab, wodurch sich der Wert des relativen Spannungsabfalls am Referenzwiderstandselement im Vergleich zum relativen Spannungsabfall im Kontaktierungsfall (Endkontaktelemente sind mit der Oberleitung kontaktiert und überbrücken das Messwiderstandselement) verringert.

Der Vorteil dieser Ausgestaltung ist in der einfachen und aufwandsarmen Detektion der Kontaktierung der Endkontaktelemente mit dem Fahrdraht zu sehen. Es kann auf aufwändige und kostenintensive Sensorelemente verzichtet werden.

Zweckdienlicherweise sind die Endkontaktelemente elektrisch leitend ausgebildet und zudem gegenüber den Kontaktbereichen elektrisch isoliert ausgebildet. Hierdurch ist insbesondere eine elektrische Trennung von Endkontaktelementen und Kontaktbereichen erreicht.

Bevorzugt sind das Messwiderstandselement und das Referenzwiderstandselement jeweils als ein Ohmscher Widerstand ausgebildet. Zudem weist ein Wert des Messwiderstandselements ein anwendungspezifisch vorgegebenes Verhältnis zu einem Wert des Referenzwiderstandselements auf.

Der Vorteil der Ohmschen Widerstände ist, dass die Widerstandselemente (Messwiderstandselement und Referenzwiderstandselement) einfach realisierbar sind und zudem einfach dimensionierbar sind. Hierdurch erreicht die Vorrichtung eine Individualisierbarkeit. Unter Individualisierbarkeit wird vorliegend speziell verstanden, dass die Vorrichtung und insbesondere die Widerstandselemente der Messvorrichtung anwendungsspezifisch dimensionierbar sind.

Gemäß einer zweckdienlichen Weiterbildung weist die Vorrichtung eine Anzahl an Widerstandselementen, beispielsweise Ohmsche Widerstände zur Strombegrenzung in einem Fehlerfall, beispielsweise einem ungewollten Kurzschluss auf. Hierdurch ist eine Ausbildung im Fehlerfall auftretender Fehlerströme verhindert. Derartige Fehlerströme entstehen beispielsweise zwischen dem Fahrzeugchassis und einer das Fahrzeugchassis berührenden Person.

Gemäß einer bevorzugten Ausbildung ist die Messvorrichtung innerhalb einer Steuereinheit des Stromabnehmers, beispielsweise der Motorkontrolleinheit einer Stromabnehmerstelleinheit integriert. Hierdurch ist beispielsweise eine kurze Leitungslänge zwischen den Endkontaktelementen und der Messvorrichtung sichergestellt.

Alternativ oder ergänzend weist die Messvorrichtung eine Auswerteeinheit auf, mittels der anhand des geänderten Spannungsabfalls die Ermittlung erfolgt, ob die Endkontaktelemente mit dem Fahrdraht kontaktiert sind. Weiterhin gibt die Auswerteinheit beispielsweise bei einer derartigen Kontaktierung ein Warnsignal an einen Führer des Kraftfahrzeuges aus. Alternativ oder ergänzend gibt die Auswerteeinheit beispielsweise ein Stellsignal an die Stromabnehmerstelleinheit aus, die beispielsweise derart ausgebildet ist, dass sie in Abhängigkeit des Stellsignals eine Korrekturbewegung des Stromabnehmers ausführt.

Bevorzugt ist das Kraftfahrzeug als ein elektromotorisch angetriebener Lastkraftwagen oder ein elektromotorisch angetriebener Bus ausgebildet.

Ausführungsbeispiele der Erfindung werden nachfolgend anhand der Figuren näher erläutert. Diese zeigen teilweise in stark vereinfachten Darstellungen:
- FIG 1: eine grob skizzierte Darstellung eines elektromotorisch angetriebenen Kraftfahrzeugs,
- FIG 2: eine perspektivische Teilansicht eines Stromabnehmers,
- FIG 3: ein grob skizziertes Schaltbild einer Messvorrichtung gemäß einer ersten Ausgestaltungsvariante,
- FIG 4: ein grob skizziertes Schaltbild der Messvorrichtung gemäß einer zweiten Ausgestaltungsvariante sowie
- FIG 5: ein grob skizziertes Schaltbild der Messvorrichtung gemäß einer dritten Ausgestaltungsvariante.

In den Figuren sind gleichwirkende Teile mit den gleichen Bezugszeichen dargestellt.

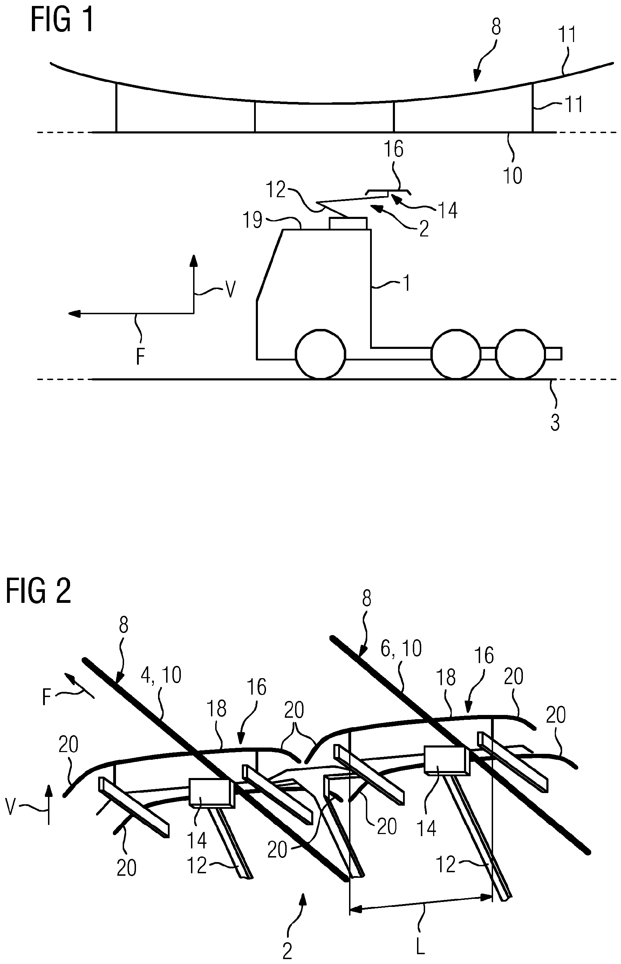

In FIG 1 ist eine grob skizzierte Darstellung eines elektromotorisch angetriebenen Kraftfahrzeuges 1 gezeigt. Das Kraftfahrzeug 1 ist im Ausführungsbeispiel als ein elektromotorisch angetriebener Lastkraftwagen ausgebildet.

Zur elektrischen Versorgung des Kraftfahrzeuges ist oberhalb einer Fahrbahn 3 eine sich in eine Fahrtrichtung F erstreckende Oberleitung 8 angeordnet. Die Oberleitung 8 weist üblicherweise einen Fahrdraht 10 sowie mehrere Tragseile 11 auf, an denen der Fahrdraht angeordnet ist. Der Fahrdraht 10 ist mit einer elektrischen Spannung beaufschlagt.

Um diese Spannung abgreifen zu können, weist das Kraftfahrzeug 1 einen Stromabnehmer 2 auf. Der Stromabnehmer 2 ist in und entgegen einer Vertikalrichtung V verfahrbar und weist einen Stromabnehmerarm 12 auf. An dem Stromabnehmerarm 12 ist ein Halteelement 14 angeordnet, welches zwei Kontaktbereiche 16 aufweist. Die Kontaktbereiche 16 sind üblicherweise als Schleifleisten 18 (in FIG 2 dargestellt) ausgebildet.

Um eine Entfernung des Stromabnehmers 2 zum Fahrdraht 10 möglichst kurz zu halten, ist der Stromabnehmer 2 im Ausführungsbeispiel auf dem Dach 19 des Kraftfahrzeuges 1 angeordnet.

Der in FIG 2 zumindest teilweise dargestellte Stromabnehmer 2 ist im Ausführungsbeispiel speziell als ein Doppelaufbau ausgebildet. D.h., dass sowohl eine elektrische Phasenleitung 4, die mit einer elektrischen Versorgungsspannung beaufschlagt ist als auch eine elektrische Masseleitung 6, die einem elektrischen Null-Potential entspricht, als eine Oberleitung 8 und insbesondere als ein Fahrdraht 10 ausgebildet sind, welche jeweils mittels einem Stromabnehmer 2 kontaktierbar sind. Der Fahrdraht 10 erstreckt sich in eine Fahrtrichtung. Der Hintergrund dieser Ausgestaltung ist, eine fehlende Masseverbindung in Form einer Schiene wie bei Schienenfahrzeugen üblich.

Aufgrund des redundanten und gleichen Aufbaus wird nachfolgend bezüglich des Stromabnehmers 2 lediglich auf den an die Phasenleitung 4 kontaktierenden Stromabnehmer 2 eingegangen. Alle aufgeführten Bauteile, Elemente und / oder Eigenschaften gelten jedoch für den Stromabnehmer 2, der mit der Masseleitung 6 kontaktiert analog.

Der Stromabnehmer 2 weist wie bereits in FIG 1 gezeigt einen Stromabnehmerarm 12 auf. An dem Stromabnehmerarm 12 ist ein Halteelement 14, auch als Wippe bezeichnet, angeordnet. Das Halteelement 14 weist im Ausführungsbeispiel zwei Kontaktbereiche 16 mit jeweils einer Schleifleiste 18 auf. Die Schleifleisten 18 dienen einer direkten Kontaktierung mit dem Fahrdraht 10, sodass die Schleifleisten 18 beispielsweise im Fahrbetrieb an dem Fahrdraht 10 entlangschleifen und somit die elektrische Versorgung des Kraftfahrzeuges sicherstellen.

Jeweils beidendseitig an die Schleifleisten 18 sind Endkontaktelemente 20 angeordnet. Die Endkontaktelemente 20 weisen im Ausführungsbeispiel eine entgegen der Vertikalrichtung V (also nach unten) gebogene Form auf, wodurch sie auch als Hörner bezeichnet werden. Die Endkontaktelemente 20 verhindern, dass der Fahrdraht 10 unter den Kontaktbereich 16 "rutscht".

Weiterhin begrenzen die Endkontaktelemente 20 einen maximal zulässigen lateralen Versatz L. Unter dem maximal zulässigen lateralen Versatz L wird vorliegend eine zum Fahrdraht 10 parallele Auslenkung des Stromabnehmers 2 und insbesondere der Schleifleisten 18 verstanden, sodass eine funktionsfähige Kontaktierung zum Fahrdraht 10 sichergestellt ist. Zugleich ist hierdurch ein maximal zulässiger lateraler Versatz des Kraftfahrzeuges vorgegeben.

Um ein Überschreiten des maximal zulässigen lateralen Versatzes L zu verhindern, weist der Stromabnehmer 2 eine Messvorrichtung auf.

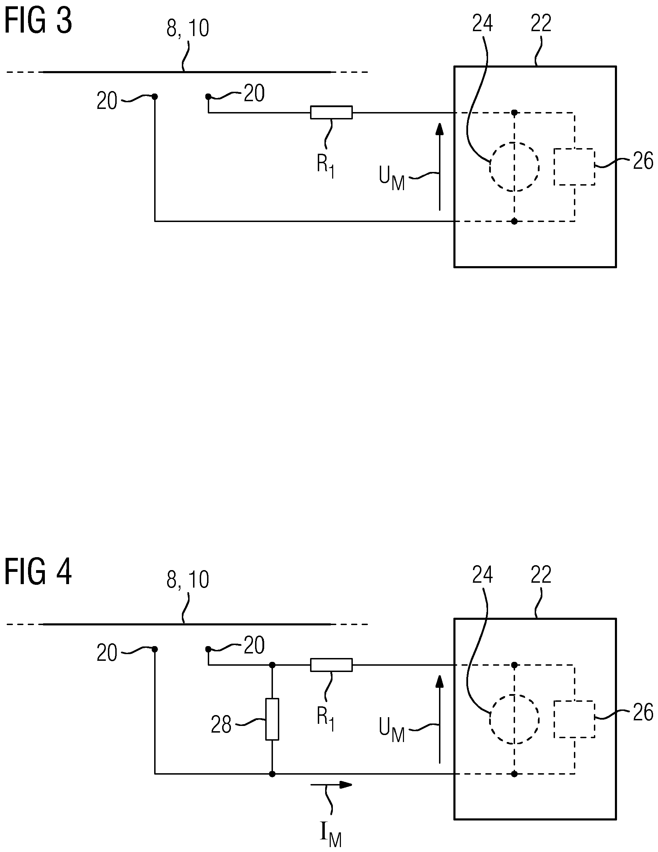

In FIG 3 ist eine derartige Messvorrichtung 22 gemäß einer ersten Ausgestaltungsvariante gezeigt. Hierbei bilden im Ausführungsbeispiel zwei Endkontaktelemente 20 ein Endkontaktelementepaar, welches mit der Messvorrichtung 22 elektrisch verbunden ist, beispielsweise drahtgebunden mittels einer elektrischen Leitung. Die elektrische Leitung ist hierzu an den Endkontaktelementen angeordnet, beispielsweise geschraubt. Mit anderen Worten: Insbesondere sind gleichendseitige Endkontaktelemente 20 mit der Messvorrichtung 22 verbunden. D.h., dass beispielsweise (in Fahrtrichtung F und den Fahrdraht 10 mittig auf den Schleifleisten 18 angeordnet betrachtet) entweder die beiden linken Endkontaktelemente 20 oder die beiden rechten Endkontaktelemente 20 mit der Messvorrichtung 22 verbunden sind. Bevorzugt sind sowohl die linken Endkontaktelemente 20 als auch die rechten Endkontaktelemente 20 mit der Messvorrichtung 22 oder jeweils mit einer Messvorrichtung 22 verbunden. Im Ausführungsbeispiel ist schematisch beispielsweise die Verbindung der zwei linken Endkontakteelementen 20 mit der Messvorrichtung 22 gezeigt.

Zur Ausbildung einer elektrischen Leitfähigkeit weisen die Endkontaktelemente 20 zumindest eine elektrisch leitfähige, beispielsweise metallisierte Oberfläche auf. Alternativ sind die Endkontaktelemente 20 aus einem Metall gebildet.

Innerhalb der Messvorrichtung 22 sind die Endkontaktelemente 20 an eine Spannungsquelle 24 angeschlossen, die eine Messspannung U_{M} generiert. Verschiebt sich nun das Kraftfahrzeug und / oder der Stromabnehmer 2 nach rechts (in Fahrtrichtung F betrachtet) so "nähert" sich der Fahrdraht 10 den linken Endkontaktelementen 20. Verschiebt sich das Kraftfahrzeug und / oder der Stromabnehmer 2 so weit nach rechts, sodass die linken Endkontaktelemente 20 an dem Fahrdraht 10 schleifen, so schließt der Fahrdraht 10 die beiden Endkontaktelemente 20 kurz und schließt somit einen Stromkreis, welcher durch die Spannungsquelle 24 innerhalb der Messvorrichtung 22 ausgebildet ist. Es fließt folglich ein Strom durch die Messvorrichtung 22, der in der Messvorrichtung 22 detektiert wird. Alternativ wird ein Widerstand erfasst. Zudem weist die Messvorrichtung 22 ein Strombegrenzungselement R₁, beispielsweise einen Ohmschen Widerstand zur Strombegrenzung auf.

Das beschriebene Verfahren erfolgt für eine Auslenkung des Kraftfahrzeuges und / oder des Stromabnehmer in Fahrtrichtung betrachtet nach links analog.

Ein Ereignis, dass die Endkontaktelemente 20 mit dem Fahrdraht 10 kontaktiert sind wird anschließend in Abhängigkeit des fließenden Stromes beispielsweise durch eine an die Messvorrichtung 22 angeschlossene Auswerteeinheit 26 erstellt und beispielsweise in Form eines Warnsignals an einen Führer des Kraftfahrzeuges und / oder in Form eines Stellsignals an eine Motorkontrolleinheit einer Stromabnehmerstelleinheit übertragen. Durch die Stromabnehmerstelleinheit erfolgt anschließend beispielsweise eine Positionskorrektur durch ein Verfahren des Stromabnehmers 2. Alternativ erfolgt eine Übertragung des Warnsignals an eine Fahrsteuerungseinheit des Kraftfahrzeuges 1, welche zur "Repositionierung" des Kraftfahrzeuges in den maximal zulässigen lateralen Versatz beispielsweise eine Lenkbewegung durchführt.

In FIG 4 ist ein grob skizziertes Schaltbild der Messvorrichtung 22 gemäß einer zweiten Ausgestaltungsvariante dargestellt.

Ergänzend zu der Schaltung gemäß FIG 3 weist die Messvorrichtung 22 neben der Spannungsquelle 24 und der Auswerteeinheit 26 ein Widerstandselement 28, beispielsweise einen Ohmschen Widerstand auf. Das Widerstandselement 28 ist im Ausführungsbeispiel parallel zu den Endkontaktelementen 20 angeschlossen. Gemäß der zweiten Ausgestaltungsvariante fließt innerhalb des Stromkreises der Messvorrichtung 22 ein Strom I_{M}, welcher in seinem Wert beispielsweise durch Wert des Widerstandselements 28 bestimmt ist. Bei einer Kontaktierung der Endkontaktelemente 20 mit dem Fahrdraht 10 wird das Widerstandselement 28 im Stromkreis elektrisch überbrückt. Diese Überbrückung beruht darauf, dass die durch die mittels des Fahrdrahts 10 kurzgeschlossenen Endkontaktelemente 20 einen parallel zu dem Widerstandselement 28 verlaufenden Strompfad ausbilden. Dieser parallele Strompfad weist jedoch einen Widerstand mit einem geringeren Wert auf als der Strompfad, in dem das Widerstandselement angeordnet ist. Somit fließt der Strom des Stromkreises bevorzugt über die Endkontaktelemente 20 und der Gesamtstrom des Stromkreises steigt an. Dieser Anstieg wird von der Messvorrichtung 22 erfasst und es erfolgt anschließend seitens der Auswerteeinheit 26 die Ausgabe des Warnsignals und/oder des Stellsignal gemäß der ersten Ausgestaltungsvariante.

Ergänzend weist die Messvorrichtung 22 gemäß der zweiten Ausgestaltungsvariante ein Strombegrenzungselement R₁, beispielsweise einen Ohmschen Widerstand zur Strombegrenzung auf.

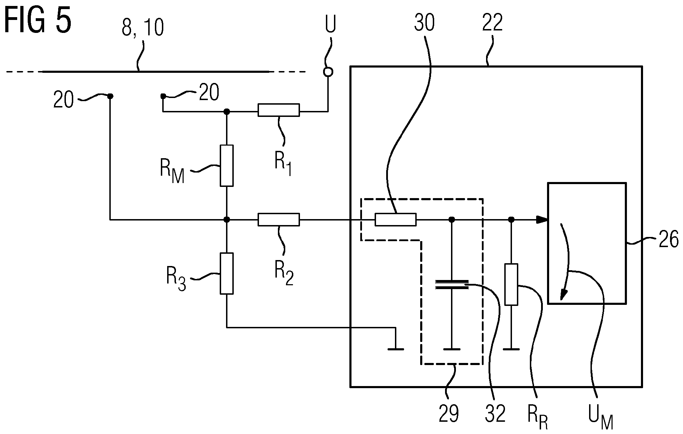

In FIG 5 ist ein grob skizziertes Schaltbild der Messvorrichtung 22 gemäß einer dritten und besonders bevorzugten Ausgestaltungsvariante gezeigt.

Die Messvorrichtung 22 gemäß FIG 4 weist ein Messwiderstandselement R_{M} und ein Referenzwiderstandselement R_{R} auf. Die beiden Widerstandselemente R_{M}, R_{R} sind beispielsweise als Ohmsche Widerstände ausgebildet. Das Messwiderstandselement R_{M} weist beispielsweise einen Wert im Bereich zwischen 50kΩ und 70kΩ auf. Das Referenzwiderstandselement R_{R} weist beispielsweise einen Wert von 10kΩ bis 20kΩ auf.

Die Widerstandselemente sind an eine Versorgungsspannung U angeschlossen und nach Art einer Spannungsteiler-Schaltung an die Messvorrichtung 22 angeschlossen. D.h. das Messwiderstandselement R_{M} ist analog zu dem Widerstandselement 28 gemäß FIG 3 parallel zu den Endkontaktelementen 20 angeschlossen. Das Referenzwiderstandselement R_{R} ist seriell an das Messwiderstandselement R_{M} angeschlossen. Eine für eine Ermittlung, ob die Endkontaktelemente 20 mit dem Fahrdraht 10 kontaktiert sind, herangezogene Messspannung U_{M} wird parallel zu dem Referenzwiderstandselement R_{R} abgegriffen. Die Versorgungsspannung U weist beispielsweise einen Wert im Bereich zwischen 6V und 30V auf.

Sind die Endkontaktelemente 20 nicht mit dem Fahrdraht 10 kontaktiert, fällt die Versorgungsspannung U an den beiden in Serie geschalteten Widerstandselementen R_{M},R_{R} ab. Die Messspannung U_{M} ergibt sich gemäß der Spannungsteiler-Regel aus der Differenz zwischen der Versorgungsspannung U und dem Wert des Spannungsabfalls am Messwiderstandselement R_{M}.

Verschiebt sich beispielsweise wie eingangs bereits beschrieben das Kraftfahrzeug derart lateral zum Fahrdraht 10 , dass die Endkontaktelemente 20 an dem Fahrdraht 10 schleifen, so schließt dieser das Messwiderstandselement R_{M} kurz und der Spannungsabfall der Versorgungsspannung U erfolgt ausschließlich am Referenzwiderstandselement R_{R}. Mit anderen Worten: Die Messspannung U_{M} entspricht der Versorgungsspannung U. Etwaige zusätzliche Spannungsabfälle aufgrund beispielsweise fertigungsbedingter Toleranzen und / oder zusätzlicher Bauteile wurden hierbei bewusst vernachlässigt.

Die Messvorrichtung 22 gemäß FIG 4 weist zudem drei Strombegrenzungselemente R₁,R₂,R₃ auf. Beispielsweise sind die Strombegrenzungselemente R₁,R₂,R₃ als Ohmsche Widerstände ausgebildet. Weiterhin weist die Messvorrichtung 22 gemäß der dritten Ausgestaltungsvariante ein Filterelement 29 beispielsweise zur Glättung von Spannungsspitzen auf. Das Filterelement 29 weist hierzu ein Filterwiderstandselement 30, beispielsweise einen Ohmschen Widerstand und einen Glättungskondensator 32 auf. Die Filterelemente 30,32 sind nach Art eines Tiefpass-Filters in der Messvorrichtung 22 angeordnet, insbesondere angeschlossen.

## Patentansprüche

1. Verfahren zur Überprüfung einer Kontaktierung zwischen einem Paar von Endkontaktelementen (20) eines Stromabnehmers (2) und einem Fahrdraht (10) einer Oberleitung (8), wobei der Stromabnehmer (2) an einem elektromotorisch angetriebenen Kraftfahrzeug (1) angeordnet ist und der Fahrdraht (10) sich in eine Fahrtrichtung (F) erstreckt, wobei der Stromabnehmer (2) zwei quer zur Fahrtrichtung (F) orientierte Kontaktbereiche (16) aufweist, die in Fahrtrichtung (F) hintereinander angeordnet sind und an denen beidendseitig jeweils ein Endkontaktelement (20) angeordnet ist, welche elektrisch leitend und gegenüber den Kontaktbereichen (16) isoliert ausgebildet sind, wobei zur Erfassung der Kontaktierung der Endkontaktelemente (20) mit der Oberleitung (8)
- ein gleichendseitig angeordnetes Paar der Endkontaktelemente (20) mit einer Messvorrichtung (22) verbunden ist und mittels der Messvorrichtung (22) eine elektrische Zustandsgröße erfasst wird sowie
- in Abhängigkeit der erfassten Zustandsgröße ermittelt wird, ob das Paar der Endkontaktelemente (20) mit der Oberleitung (8) kontaktiert ist.

2. Verfahren nach dem vorhergehenden Anspruch,
wobei die erfasste elektrische Zustandsgröße eine elektrische Spannung ist.

3. Verfahren nach einem der beiden vorhergehenden Ansprüche, wobei die Messvorrichtung (22) eine Spannungsquelle (24) aufweist und von der Spannungsquelle (24) mit einer Versorgungsspannung versorgt wird.

4. Verfahren nach einem der vorhergehenden Ansprüche, wobei die Messvorrichtung (22) zumindest ein Messwiderstandselement (R_{M}) und ein Referenzwiderstandselement (R_{R}) aufweist und durch die Messvorrichtung (22)ein Spannungsabfall über das Referenzwiderstandselement (R_{R}) ermittelt wird, wobei der Spannungsabfall in Abhängigkeit einer Kontaktierung der Endkontaktelemente (22) mit der Oberleitung (8) variiert.

5. Verfahren nach dem vorhergehenden Anspruch, wobei bei einer Kontaktierung der Kontaktbereiche (16) mit der Oberleitung (8) der Spannungsabfall über das Messwiderstandselement (R_{M}) und das Referenzwiderstandselement (R_{R}) erfolgt.

6. Verfahren nach einem der beiden vorhergehenden Ansprüche, wobei bei einer Kontaktierung der Endkontaktelemente (20) mit der Oberleitung (8) das Messwiderstandselement (R_{M}) überbrückt wird und der Spannungsabfall lediglich über das Referenzwiderstandselement (R_{R}) erfolgt.

7. Verfahren nach einem der vorhergehenden Ansprüche, wobei bei einer ermittelten Kontaktierung des Paares der Endkontaktelemente (20) mit der Oberleitung (8) ein Warnsignal ausgegeben wird.

8. Vorrichtung zur Überprüfung einer Kontaktierung eines Paares von Endkontaktelementen (20) eines an einem elektromotorisch angetriebenen Kraftfahrzeug (1) angeordneten Stromabnehmers (2) mit einem sich in eine Fahrtrichtung (F) erstreckenden Fahrdraht (10) einer Oberleitung (8), wobei die Vorrichtung aufweist:
- den Stromabnehmer (2) mit
- zwei quer zur Fahrtrichtung (F) orientierten Kontaktbereichen (16), die in Fahrtrichtung (F) hintereinander angeordnet sind und an denen beidendseitig jeweils ein Endkontaktelement (20) angeordnet ist, welche elektrisch leitend und gegenüber den Kontaktbereichen (16) isoliert ausgebildet sind, sowie
- eine Messvorrichtung (22) zur Erfassung der Kontaktierung der Endkontaktelemente (20) mit der Oberleitung (8), wobei
- ein gleichendseitig angeordnetes Paar der Endkontaktelemente (22) mit der Messvorrichtung (22) verbunden ist und mittels der Messvorrichtung (22) eine elektrische Zustandsgrö-ße erfassbar ist sowie
- die Messvorrichtung (22) derart ausgebildet ist, dass in Abhängigkeit der erfassten Zustandsgröße eine Ermittlung erfolgt, ob das Paar der Endkontaktbereiche (20) mit der Oberleitung (8) kontaktiert ist.

9. Vorrichtung nach dem vorhergehenden Anspruch, wobei die Messvorrichtung (22) ein Messwiderstandselement (R_{M}) und ein Referenzwiderstandselement (R_{R}) aufweist, sodass in Abhängigkeit einer Kontaktierung der Endkontaktelemente (20) mit der Oberleitung (8) ein unterschiedlicher Spannungsabfall über das Referenzwiderstandselement (R_{R}) erfassbar ist.

10. Vorrichtung nach einem der beiden vorhergehenden Ansprüche, wobei die Endkontaktelemente (20) elektrisch leitend ausgebildet sind und gegenüber den Kontaktbereichen (16) isoliert sind.

11. Vorrichtung nach einem der beiden vorhergehenden Ansprüche, wobei das Messwiderstandselement (R_{M}) und das Referenzwiderstandselement (R_{R}) als ein Ohmscher Widerstand ausgebildet sind.

12. Vorrichtung nach einem der Ansprüche 8 bis 10, wobei sie eine Anzahl an Widerstandselementen (R₁,R₂,R₃) zur Strombegrenzung aufweist.

13. Vorrichtung nach einem der Ansprüche 8 bis 11, wobei die Messvorrichtung (22) innerhalb einer Steuereinheit des Stromabnehmers (2) integriert ist.

14. Vorrichtung nach einem der Ansprüche 8 bis 12, wobei das elektromotorisch angetriebene Kraftfahrzeug (1) als ein elektromotorisch angetriebener Lastkraftwagen ausgebildet ist.

## Claims

1. Method for testing whether there is a contact between a pair of end contact elements (20) of a current collector (2) and a contact wire (10) of an overhead line (8), wherein the current collector (2) is located on a motor vehicle (1) driven by an electric motor and the contact wire (10) extends in a direction of travel (F), wherein the current collector (2) has two contact regions (16) oriented transversely to the direction of travel (F) which are arranged one behind the other in the direction of travel (F) and on each of which an end contact element (20) is located at both ends, which are electroconductive and are isolated from the contact regions (16), wherein for the detection of contact of the end contact elements (20) with the overhead line (8)
- a pair of end contact elements (20) located on the same end side is connected to a measuring device (22) and an electrical state variable is detected by means of the measuring device (22) and
- it is determined in accordance with the detected state variable whether the pair of end contact elements (20) is in contact with the overhead line (8).

2. Method according to the preceding claim,
wherein the detected electrical state variable is an electrical voltage.

3. Method according to one of the two preceding claims, wherein the measuring device (22) has a voltage source (24) and is supplied with a power supply voltage by the voltage source (24).

4. Method according to one of the preceding claims, wherein the measuring device (22) has at least one measuring resistance element (R_{M}) and one reference resistance element (R_{R}) and a voltage drop via the reference resistance element (R_{R}) is determined by the measuring device (22), wherein the voltage drop varies depending on the contact between the end contact elements (22) and the overhead line (8).

5. Method according to the preceding claim, wherein the voltage drop takes place via the measuring resistance element (R_{M}) and the reference resistance element (R_{R}) when the contact regions (16) are in contact with the overhead line (8) .

6. Method according to one of the two preceding claims, wherein the measuring resistance element (R_{M}) is bridged and the voltage drop only takes place via the reference resistance element (R_{R}) when the end contact elements (20) are in contact with the overhead line (8).

7. Method according to one of the preceding claims, wherein a warning signal is output when the pair of end contact elements (20) is in contact with the overhead line (8).

8. Device for testing whether there is contact between a pair of end contact elements (20) of a current collector (2) located on a motor vehicle (1) driven by an electric motor and a contact wire (10) of an overhead line (8) extending in a direction of travel (F), wherein the device has:
- the current collector (2) with
- two contact regions (16) oriented transversely to the direction of travel (F) which are arranged one behind the other in the direction of travel (F) and on each of which an end contact element (20) is located at both ends, which are electroconductive and are isolated from the contact regions (16),and
- a measuring device (22) for the detection of contact of the end contact elements (20) with the overhead line (8), wherein
- a pair of end contact elements (22) located on the same end side is connected to the measuring device (22) and an electrical state variable can be detected by means of the measuring device (22) and
- the measuring device (22) is designed such that depending on the detected state variable, it is determined whether the pair of end contact regions (20) is in contact with the overhead line (8).

9. Device according to the preceding claim, wherein the measuring device (22) has a measuring resistance element (R_{M}) and a reference resistance element (R_{R}) so that, depending on whether the end contact elements (20) are in contact with the overhead line (8), a different voltage drop can be detected via the reference resistance element (R_{R}).

10. Device according to one of the two preceding claims, wherein the end contact elements (20) are electroconductive and are isolated from the contact regions (16).

11. Device according to one of the two preceding claims, wherein the measuring resistance element (R_{M}) and the reference resistance element (R_{R}) are designed as an ohmic resistor.

12. Device according to one of claims 8 to 10, wherein it has a number of resistance elements (R₁, R₂, R₃) for current limitation.

13. Device according to one of claims 8 to 11, wherein the measuring device (22) is integrated within a control unit of the current collector (2).

14. Device according to one of claims 8 to 12, wherein the motor vehicle (1) driven by an electric motor is designed as a truck driven by an electric motor.

## Revendications

1. Procédé de contrôle de la mise en contact entre une paire d'éléments (20) d'extrémité de contact d'un appareil (2) de prise de courant et un fil (10) de contact d'une ligne (8) de contact, dans lequel l'appareil (2) de prise de courant est monté sur un véhicule (1) automobile entraîné par moteur électrique et le fil (10) s'étend dans un sens (F) de circulation, dans lequel l'appareil (2) de prise de contact a deux parties (16) de contact, orientées transversalement au sens (F) de circulation, qui sont disposées l'une derrière l'autre dans le sens (F) de circulation et sur lesquelles est monté des deux côtés respectivement, un élément (20) d'extrémité de contact, qui sont constitués en étant conducteurs électriquement et isolés par rapport aux parties (16) de contact, dans lequel, pour la détection de la mise en contact des éléments (20) d'extrémité de contact avec la ligne (8) de contact
- une paire, disposée du même côté des éléments (20) d'extrémité de contact, est reliée à un montage (22) de mesure et on détecte une grandeur électrique d'état, au moyen du montage (22) de mesure, ainsi que
- on détermine, en fonction de la grandeur d'état détectée, si la paire des éléments (20) d'extrémité de contact est en contact avec la ligne (8) de contact.

2. Procédé suivant la revendication précédente, dans lequel la grandeur électrique d'état détectée est une tension électrique.

3. Procédé suivant l'une des deux revendications précédentes, dans lequel le montage (22) de mesure a une source (24) de tension et on l'alimente en une tension d'alimentation par la source (24) de tension.

4. Procédé suivant l'une des revendications précédentes, dans lequel le montage (22) de mesure a au moins un élément (R_{M}) résistant de mesure et un élément (R_{R}) résistant de référence et on détermine, par le montage (22) de mesure, une chute de tension aux bornes de l'élément (R_{R}) résistant de référence, dans lequel la chute de tension varie, en fonction de la mise en contact des éléments (22) d'extrémité de contact avec la ligne (8) de contact.

5. Procédé suivant la revendication précédente, dans lequel, lors de la mise en contact des parties (16) de contact avec la ligne (8) de contact, la chute de tension a lieu par l'intermédiaire de l'élément (R_{M}) résistant de mesure et de l'élément (R_{R}) résistant de référence.

6. Procédé suivant l'une des deux revendications précédentes, dans lequel, lors de la mise en contact des éléments (20) d'extrémité de contact avec la ligne (8) de contact, on shunte l'élément (R_{M}) résistant de mesure et la chute de tension a lieu seulement par l'élément (R_{R}) résistant de référence.

7. Procédé suivant l'une des revendications précédentes, dans lequel, lorsque la mise en contact de la paire des éléments (20) d'extrémité de contact avec la ligne (8) de contact est déterminée, on émet un signal d'alerte.

8. Dispositif de contrôle d'une mise en contact d'une paire d'éléments (20) d'extrémité de contact d'un appareil (2) de prise de courant monté sur un véhicule (1) automobile entraîné par moteur électrique, comprenant un fil (10) de contact, s'étendant dans le sens (F) de circulation, d'une ligne (8) de contact, dans lequel le dispositif a :
- l'appareil (2) de prise de courant comprenant
- deux parties (16) orientées transversalement au sens (F) de circulation, qui sont disposées l'une derrière l'autre dans le sens (F) de circulation et sue lesquelles est disposé, des deux côtés respectivement, un élément (20) d'extrémité de contact, qui sont constitués d'une manière conductrice de l'électricité et isolés par rapport aux parties (16) de contact, ainsi que
- un montage (22) de mesure pour la détection de la mise en contact des éléments (20) d'extrémité de contact avec la ligne (8) de contact, dans lequel
- une paire, disposée du même côté des éléments (22) d'extrémité de contact, est reliée au montage (22) de mesure et une grandeur électrique d'état peut être détectée au moyen du montage (22) de mesure, ainsi que
- le montage (22) de mesure est conformé de manière à ce que, en fonction de la grandeur d'état détectée, il soit effectué une détermination du point de savoir si la paire des parties (20) d'extrémité de contact est en contact avec la ligne (8) de contact.

9. Dispositif suivant la revendication précédente, dans lequel le montage (22) de mesure a un élément (R_{M}) résistant de mesure et un élément (R_{R}) résistant de référence, de manière à pouvoir, en fonction d'une mise en contact des éléments (20) d'extrémité de contact avec la ligne (8) de contact, détecter une chute de tension différente aux bornes de l'élément (R_{R}) résistant de référence.

10. Dispositif suivant l'une des deux revendications précédentes, dans lequel les éléments (20) d'extrémité de contact sont conducteurs de l'électricité et isolés par rapport aux parties (16) de contact.

11. Dispositif suivant l'une des deux revendications précédentes, dans lequel l'élément (R_{M}) résistant de mesure et l'élément (R_{R}) résistant de référence sont sous la forme d'une résistance ohmique.

12. Dispositif suivant l'une des revendications 8 à 10, dans lequel il a un certain nombre d'éléments (R₁, R₂, R₃) résistants pour la limitation du courant.

13. Dispositif suivant l'une des revendications 8 à 11, dans lequel le montage (22) de mesure est intégré au sein d'une unité de commande de l'appareil (2) de prise de courant.

14. Dispositif suivant l'une des revendications 8 à 12, dans lequel le véhicule (1) automobile entraîné par moteur électrique est constitué d'un camion entraîné par moteur électrique.
